# EUROPEAN PATENT APPLICATION

(11) **EP 2 848 672 A1**
(43) Date of publication of application: **18.03.2015**
(21) Application number: 13835090.5
(22) Date of filing: 29.05.2013
(51) Int. Cl.: C09K 11/65, C09K 11/02, H01L 33/32

(54) **SiC FLUORESCENT MATERIAL, METHOD FOR PRODUCING SAME AND LUMINESCENT ELEMENT**

(30) Priority: 04.09.2012 JP 2012194383
(71) Applicant: EL-Seed Corporation, Nagoya-shi, Aichi 468-0004 (JP)
(72) Inventor: MAEDA, Tomohiko, Nagoya-shi Aichi 468-0004 (JP); TERAMAE, Fumiharu, Nagoya-shi Aichi 468-0004 (JP); NANIWAE, Koichi, Nagoya-shi Aichi 468-0004 (JP)
(74) Representative: Engel, Christoph Klaus
(86) International application number: PCT/JP2013/064953
(87) International publication number: WO 2014/038255

(57) **Abstract**

Provided are a SiC fluorescent material with improved luminous efficiency, a method for manufacturing the same and a light emitting element. A SiC fluorescent material comprises a SiC crystal in which a carbon atom is disposed in a cubic site and a hexagonal site, and a donor impurity and an acceptor impurity added therein, wherein a ratio of a donor impurity to be substituted with a carbon atom in a cubic site to a donor impurity to be substituted with a carbon atom in a hexagonal site is larger than a ratio of the cubic site to the hexagonal site in a crystal structure.

## Description

The present invention relates to a SiC fluorescent material and a method for manufacturing the same, and a light emitting element.

### [Background Art]

A light emitting diode (LED) has widely been put into practice as a light emitting element due to p-n junction of a compound semiconductor, and has mainly used in optical transmission, display and lighting applications. Since white LED has insufficient energy conversion efficiency as compared with an existing fluorescent lamp, there is a need to perform significant improvement in efficiency to general lighting applications. There remain many issues in realization of LED having high color rendering properties, low cost, and large luminous flux.

Currently marketed white LEDs are commonly equipped with a blue light-emitting diode element mounted on a lead frame, a yellow phosphor layer consisting of YAG:Ce covered with this blue light-emitting diode element, and a molded lens consisting of a transparent material such as an epoxy resin, which covers them. In the white LEDs, when blue light is emitted from the blue light-emitting diode element, blue light is partially converted into yellow light in the case of passing through the yellow phosphor. Since blue color and yellow color have complementary color relation to each other, blue light and yellow light are mixed to obtain white light. In the white LEDs, there is a need to perform an improvement in performances of the blue light-emitting diode element so as to improve efficiency and to improve color rendering properties.

There has been known, as the blue light-emitting diode element, a blue light-emitting diode element comprising, on an n-type SiC substrate, a buffer layer consisting of AlGaN, an n-type GaN layer consisting of n-GaN, a multiple quantum well active layer consisting of GaInN/GaN, an electron blocking layer consisting of p-AlGaN, and a p-type contact layer consisting of p-GaN laminated successively from the SiC substrate side in this order. In this blue light-emitting diode element, a p-side electrode is formed on a front surface of the p-type contact layer and also an n-side electrode is formed on a back surface of the SiC substrate, and an electric current is allowed to flow by applying a voltage between the p-side electrode and the n-side electrode, whereby, blue light is emitted from the multiple quantum well active layer. Here, since the SiC substrate has conductivity, unlike the blue light-emitting diode element using a sapphire substrate, it is possible to dispose electrodes one above the other, and to attempt to making simplification of the manufacturing process, in-plane uniformity of an electric current, effective utilization of a light-emitting area to a chip area, and the like.

There has also been proposed a light emitting diode element which produces white light alone without utilizing a phosphor (see, for example, Patent Document 1). In this light emitting diode element, a fluorescent SiC substrate including a first SiC layer doped with B and N and a second SiC layer doped with Al and N is used in place of the n-type SiC substrate of the above-mentioned blue light-emitting diode element, thus emitting near ultraviolet rays from the multiple quantum well active layer. Near ultraviolet rays are absorbed to the first SiC layer and the second SiC layer, and thus near ultraviolet rays are converted into visible rays ranging in color of green to red in the first SiC layer and near ultraviolet rays are converted into visible rays ranging in color of blue to red in the second SiC layer, respectively. As a result, white light having high color rendering properties near the sunlight is emitted from the fluorescent SiC substrate.

### [Citation List]

### [Patent Literature]

[Patent Literature 1]
JP 4153455 B1

### [Summary of Invention]

### [Technical Problem]

The inventors of the present application have further studied intensively about an improvement in luminance efficiency of a SiC fluorescent material.

The present invention has been made in view of the above circumstances and an object thereof is to provide a SiC fluorescent material having improved luminance efficiency and a method for manufacturing the same, and a light emitting element.

### [Solution to Problem]

In order to achieve the above object, in the present invention, there is provided a fluorescent material including a SiC crystal in which a carbon atom is disposed in a cubic site and a hexagonal site, and a donor impurity and an acceptor impurity added therein, wherein a ratio of a donor impurity to be substituted with a carbon atom in a cubic site to a donor impurity to be substituted with a carbon atom in a hexagonal site is larger than a ratio of the cubic site to the hexagonal site in a crystal structure.

In the above-mentioned SiC fluorescent material, the carrier concentration at room temperature is preferably smaller than a difference between the donor concentration and the acceptor concentration.

In the above-mentioned SiC fluorescent material, an absorbance in a visible light region is preferably about the same level as that in the case of adding no impurity.

In the present invention, there is also provided a method for manufacturing a SiC fluorescent material, which includes growing the SiC fluorescent material in a hydrogen-containing atmosphere by a sublimation method in the manufacture of the above-mentioned SiC fluorescent material.

In the present invention, there is also provided a light emitting element including a SiC substrate including the above-mentioned SiC fluorescent material, and a nitride semiconductor layer formed on the SiC substrate.

### [Advantageous Effects of Invention]

According to the present invention, it is possible to improve luminance efficiency of a SiC fluorescent material.

### [Brief Description of Drawings]

- Fig. 1:: is a schematic cross-sectional view of a light emitting diode element, which shows one embodiment of the present invention.
- Fig. 2:: is a schematic view of a 6H-type SiC crystal.
- Fig. 3:: is an explanatory view schematically showing a state where light incident on a SiC substrate is converted into fluorescence.
- Fig. 4:: is an explanatory view of a crystal growth apparatus.
- Fig. 5:: is a table showing a relative emission intensity, a carrier concentration at room temperature, a difference between a donor impurity and an acceptor impurity, a ratio of Hall to the difference, and a ratio of a donor forming a shallow donor level to a donor forming a deep donor level of samples A and B.
- Fig. 6:: is a graph showing a relation between the wavelength and the light transmittance of samples A, B, and C.

### [Description of Embodiments]

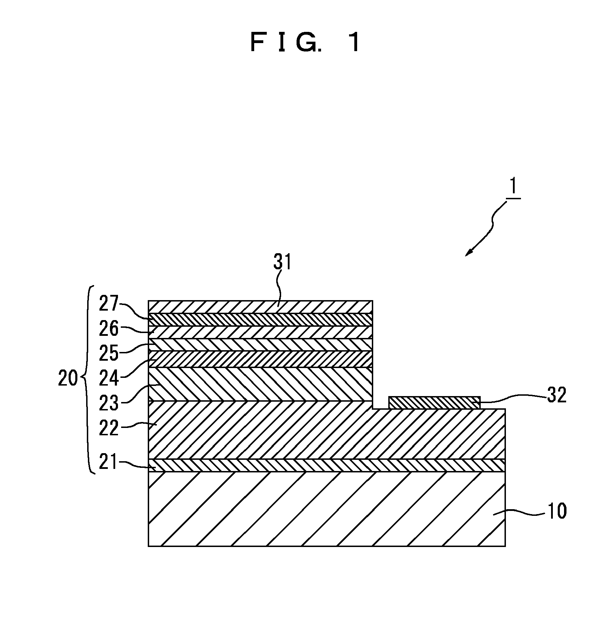

Fig. 1 to Fig. 4 show one embodiment of the present invention, and Fig. 1 is a schematic cross-sectional view of a light emitting diode element.

As shown in Fig. 1, a white light emitting diode 1 includes a SiC substrate 10 doped with boron (B) and nitrogen (N), and a light-emitting portion 20 composed of a plurality of nitride semiconductor layers formed on the SiC substrate 10. When light is incident on the SiC substrate 10 from the light-emitting portion 20, incident light is absorbed to the SiC substrate 10 to produce fluorescence due to an impurity level.

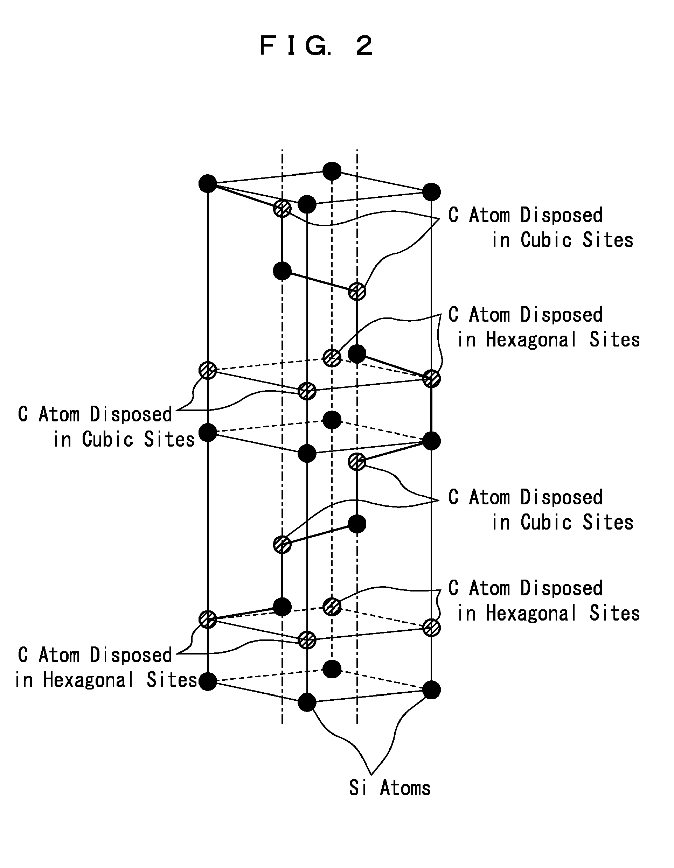

As shown in Fig. 2, a SiC substrate 10 is formed of a 6H-type SiC crystal having a periodic structure every six layers, and contains nitrogen as a donor impurity and also contains boron as an acceptor impurity. A method for manufacturing a SiC substrate 10 is optional and, for example, the SiC substrate can be manufactured by growing a SiC crystal using a sublimation method or a chemical vapor deposition method. At this time, it is possible to optionally set the concentration of nitrogen in the SiC substrate 10 by appropriately adjusting a partial pressure of a nitrogen gas (N₂) in an atmosphere during the crystal growth. Meanwhile, it is possible to optionally set the concentration of boron in the SiC substrate 10 by mixing a moderate amount of a boron simple substance or a boron compound with a raw material.

Here, the cubic site accounts for two-thirds of the 6H-type SiC crystal, while the hexagonal site accounts for one-thirds thereof. Commonly, nitrogen as the donor impurity is disposed in each site in the same proportion as the presence proportion. In other words, in the case of 6H-type SiC, two-thirds of the nitrogen is substituted with the carbon atom in the cubic site and one-thirds of the nitrogen is substituted with the carbon atom in the hexagonal site. However, since the SiC crystal of the present embodiment is manufactured through the step of operating a donor so as to increase the concentration of a donor impurity in the cubic site, and thus a ratio of a donor impurity to be substituted with a carbon atom in a cubic site to a donor impurity to be substituted with a carbon atom in a hexagonal site is larger than a ratio of the cubic site to the hexagonal site in a crystal structure.

As shown in Fig. 1, a light-emitting portion 20 includes a buffer layer 21 composed of AlGaN, a first contact layer 22 composed of n-GaN, a first clad layer 23 composed of n-AlGaN, a multiple quantum well active layer 24 composed of GaInN/GaN, an electron blocking layer 25 composed of p-AlGaN, a second clad layer 26 composed of p-AlGaN, and a second contact layer 27 composed of p-GaN in this order from the SiC substrate 10. The light-emitting portion 20 is laminated on the SiC substrate 10 by, for example, metal organic vapor phase epitaxy. On a front surface of the second contact layer 27, a p-electrode 31 consisting of Ni/Au is formed. The first contact layer 22 is exposed by etching from the second contact layer 27 to a predetermined position of the first contact layer 22 in a thickness direction, and an n-electrode 32 consisting of Ti/Al/Ti/Au is formed on this exposed portion.

In the present embodiment, a multiple quantum well active layer 108 is consisting of Ga_{0.95}In_{0.05}N/GaN, and an emission peak wavelength is 385 nm. The peak wavelength in the multiple quantum well active layer 24 can be optionally changed. As long as at least a first conductivity-type layer, an active layer, and a second conductivity-type layer are included and, when a voltage is applied to the first conductivity-type layer and the second conductivity-type layer, light is emitted by the recombination of electrons and holes in the active layer, layer configuration of the light-emitting portion 20 is optional.

When a forward voltage is applied to a p-electrode 31 and an n-electrode 32 of the white light emitting diode 1 thus configured as mentioned above, an electric current is injected into the light-emitting portion 20 to emit light having a peak wavelength in a near ultraviolet region in the multiple quantum well active layer 24. Near ultraviolet rays thus emitted are incident on the SiC substrate 10 doped with acceptor and donor impurity, and thus almost all of near ultraviolet rays are absorbed. In the SiC substrate 10, when donor electrons and acceptor holes are recombined using near ultraviolet rays as excitation light, fluorescence is produced to emit light ranging in color from yellow to red. Whereby, the white light emitting diode 1 emits warm white light and thus light suited for lighting is emitted outside.

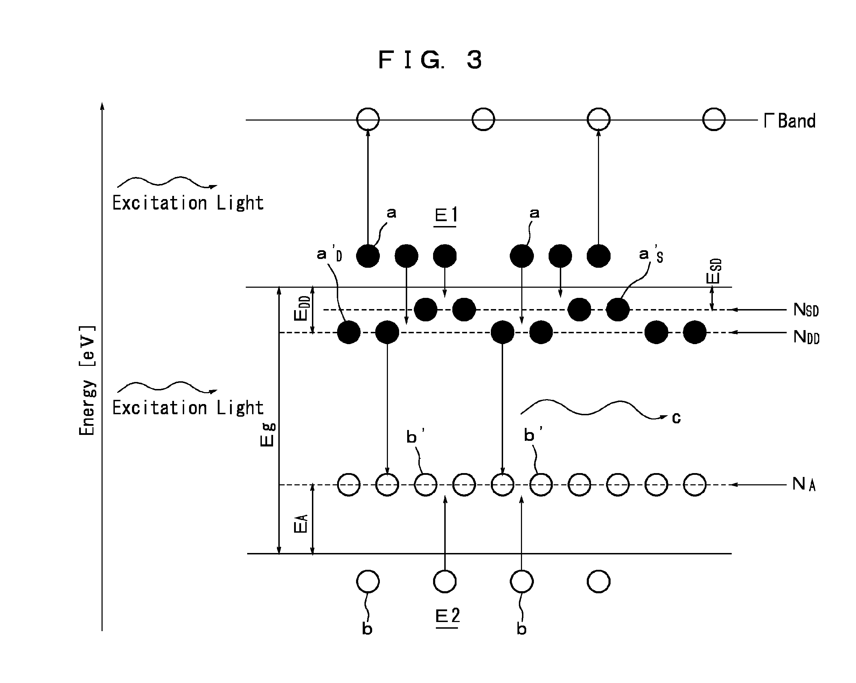

Here, the fluorescence action in the SiC substrate 10 will be described with reference to Fig. 3. Fig. 3 is an explanatory view schematically showing a state where light incident on a SiC substrate is converted into fluorescence.

Since the SiC substrate 10 is mainly composed of a SiC crystal, band gap energy E_{g} of a 6H-type SiC crystal is formed.

When light is incident on the SiC substrate 10, free electron "a" is excited from a valence band E2 to a conduction band E1 to produce free hole "b" at E2. In a short time of from several ns to several µs, free electron "a" becomes donor electrons a_{S}', a_{D}' by relaxation to donor levels N_{SD}, N_{DD}, while free hole "b" become acceptor hole b' by relaxation to an acceptor level N_{A}.

Here, it has already been found that the donor in the cubic site forms a deep donor level N_{DD}, while the donor in the hexagonal site forms a shallow donor level N_{SD}.

Donor electron a_{D}' relaxed to the deep donor level N_{DD} is used for donor-acceptor pair (DAP) emission, and is recombined with acceptor hole b'. Then, photon c with energy corresponding to the transition energy (E_{g} - E_{DD} - E_{A}) is emitted out of the SiC substrate 10. The wavelength of photon c emitted out of the SiC substrate 10 depends on the transition energy (E_{g} - E_{DD}-E_{A}).
Meanwhile, donor electron aₛ' relaxed to the shallow donor level N_{SD} is used for in-band absorption with a Γ band, and is not recombined with acceptor hole b'. In other words, it does not contribute to light emission.

In order to accurately perform donor-acceptor pair emission, the carrier concentration at room temperature in the SiC crystal is preferably smaller than a difference between the donor concentration and the acceptor concentration.

Furthermore, since ionization energy of nitrogen is smaller than that of boron, nitrogen is ionized to some extent at room temperature. Therefore, excited donor electron a_{D}' transits again to the conduction band E1, resulting in lacking of donor electron a_{D}' which forms a pair together with acceptor hole b'. Acceptor hole b' free from donor electron a_{D}', which forms a pair together with acceptor hole b', cannot contribute to emission of fluorescence, leading to waste consumption of energy for exciting the acceptor hole b'. In other words, it is possible to realize high fluorescence quantum efficiency by setting the concentration of nitrogen at the concentration larger than that of boron through foreseeing of the amount of nitrogen to be ionized so that donor electron a_{D}' and acceptor hole b' can be recombined in just proportion.

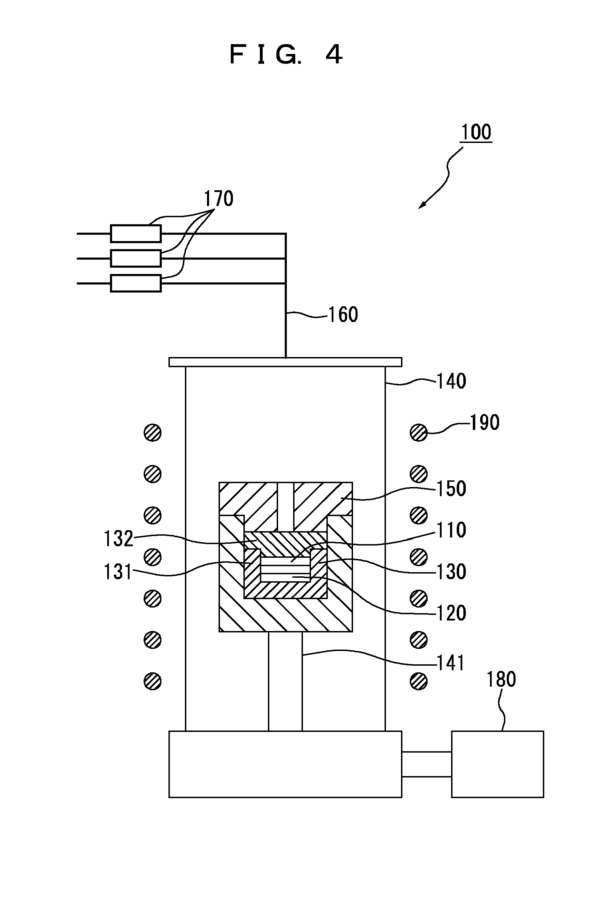

The method for manufacturing a SiC fluorescent material will be described below with reference to Fig. 4. Fig. 4 is an explanatory view of a crystal growth apparatus.

As shown in Fig. 4, this crystal growth apparatus 100 includes an inner container 130 in which a seed crystal substrate 110 and a raw material 120 are disposed, a storage tube 140 for accommodating an inner container 130, a heat insulating container 150 for covering the inner container 130, an introduction tube 160 for introducing a gas into the storage tube 140, a flowmeter 170 for measuring a flow rate of a gas to be introduced from the introduction tube 160, a pump 180 for adjusting a pressure in the storage tube 140, and an RF coil 190 for heating the seed crystal substrate 110, disposed outside the storage tube 140.

The inner container 130 is consisting of graphite, for example, and includes a crucible 131 having a top opening and a lid 132 for closing the opening of the crucible 131. The seed crystal substrate 110 consisting of a single crystal SiC is attached to the inner surface of the lid 132. A raw material 120 for sublimation recrystallization is accommodated inside the crucible 131. In the present embodiment, a powder of a SiC crystal and a powder serving as a source B are used as the raw material 120. Examples of the source B include LaB₆, B₄C, TaB₂, NbB₂, ZrB₂, HfB₂, BN, carbon containing B, and the like.

In the manufacture of a SiC fluorescent material, first, the crucible 131 filled with the raw material 120 is closed with the lid 132 and, after disposing inside the storage tube 140 using a support rod 141 consisting of graphite, the inner container 130 is covered with the heat insulating container 150. Then, an Ar gas, a N₂ gas, and a H₂ gas, as an atmospheric gas, are allowed to flow into the storage tube 140 by the introduction tube 160 via the flowmeter 170. Subsequently, the raw material 120 is heated using the RF coil 190, and the pressure in the storage tube 140 is controlled using the pump 180.

Specifically, the pressure in the storage tube 140 is controlled within a range from 0.03 Pa to 600 Pa and the initial temperature of the seed crystal substrate 110 is controlled to at least 1,100°C. The initial temperature is preferably 1,500°C or lower, and more preferably 1,400°C or lower. Then, temperature gradient between the raw material 120 and the seed crystal substrate 110 is set within a range from 1°C to 10°C.

Then, the seed crystal substrate 110 is heated from the initial temperature to the growth temperature at 15°C/minute to 25°C/minute. The growth temperature is preferably set within a range from 1,700°C to 1,900°C. The growth rate is preferably set within a range from 10 µm/hour to 200 µm/hour.

Whereby, the raw material 120 diffuses in the direction of the seed crystal substrate 110 due to concentration gradient formed based on temperature gradient after sublimation, and then transported. The growth of the SiC fluorescent material is realized by recrystallization of a raw material gas, which reached the seed crystal substrate 110, on a seed crystal. The doping concentration in the SiC crystal is controlled by the addition of an impurity gas in an atmospheric gas during the crystal growth, and the addition of an impurity element or a compound thereof to a raw material powder.

In the present embodiment, a N₂ gas is added in the atmospheric gas during the crystal growth and a compound of B is added to the raw material 120. Furthermore, a H₂ gas is added in the atmospheric gas during the crystal growth, thus suppressing substitution with carbon atom in the hexagonal site of a donor impurity, leading to acceleration of substitution with carbon atoms in the cubic site. This mechanism is considered as follows.

First, hydrogen atom reacts with carbon atom at the atomic step end of a crystal growth front surface to form a C-H bond.
Then, a bonding force between carbon atom and surrounding silicon atom decreases to generate carbon vacancy due to elimination of carbon atom, leading to an increase in a probability that nitrogen is incorporated into carbon vacancy. Here, since there is a difference in a bonding force of surrounding Si atom between carbon atom in the hexagonal site and carbon atom in the cubic site, and carbon atom in the cubic site has a weak bonding force, carbon vacancy is likely to be generated by hydrogen atom, thus considering that substitution of carbon atom in the cubic site with nitrogen atom is selectively accelerated.

As mentioned above, in the SiC crystal manufactured through the donor operation step of accelerating substitution of carbon atom in the cubic site with nitrogen atom, as compared with carbon atom in the hexagonal site, in which a SiC fluorescent material is grown by a sublimation method in a hydrogen-containing atmosphere, a ratio of a donor impurity to be substituted with a carbon atom in a cubic site to a donor impurity to be substituted with a carbon atom in a hexagonal site is larger than a ratio of the cubic site to the hexagonal site in a crystal structure.

The SiC crystal thus manufactured can improve luminance efficiency upon donor-acceptor pair (DAP) emission because of high ratio of a donor impurity contributing to fluorescence as compared with a conventional one manufactured through no donor operation step. At this time, it is preferable that an absorbance in a visible light region in the SiC crystal is about the same level as that in the case of adding no impurity because of little donor having a shallow level.

The SiC crystal thus manufactured becomes a SiC substrate 10 by passing through the steps of external grinding, slicing, front surface grinding, front surface polishing, and the like. Thereafter, a group III nitride semiconductor is epitaxially grown on the SiC substrate 10. In the present embodiment, for example, a buffer layer 21, a first contact layer 22, a first clad layer 23, a multiple quantum well active layer 24, an electron blocking layer 25, a second clad layer 26, and a second contact layer 27 are grown by metal organic vapor phase epitaxy. A nitride semiconductor layer is formed and the respective layers 31, 32 are formed, followed by division into a plurality of light emitting diode elements 1 through dicing to manufacture a light emitting diode element 1. Here, the SiC substrate 10 shown in Fig. 1 can also be used as a phosphor plate without being used as a substrate of the light emitting diode element 1.

Actually, sample A was manufactured, a ratio of a donor impurity to be substituted with a carbon atom in a cubic site to a donor impurity to be substituted with a carbon atom in a hexagonal site being larger than a ratio of the cubic site to the hexagonal site, with respect to a crystal structure in a 6H-type SiC crystal. For comparison, sample B was manufactured, a ratio of a donor impurity to be substituted with a carbon atom in a cubic site to a donor impurity to be substituted with a carbon atom in a hexagonal site being the same as a ratio of the cubic site to the hexagonal site, with respect to a crystal structure in a 6H-type SiC crystal.

Specifically, samples A and B were manufactured using a crystal growth apparatus shown in Fig. 4, and nitrogen was used as a donor impurity and boron was used as an acceptor impurity. Nitrogen was added by allowing a N₂ gas to contain in an atmospheric gas and boron was added by allowing a compound of B to contain in a raw material 120. More specifically, samples A and B were manufactured under the conditions of an initial temperature of 1,100°C, a growth temperature of 1,780°C, and a growth rate of 100 µm/hour. Sample A was manufactured by introducing, in addition to an Ar gas and a N₂ gas, a H₂ gas into a storage tube 140, and setting the pressure in the storage tube 140 at 0.08 Pa. Sample B was manufactured by introducing an Ar gas and a N₂ gas into a storage tube 140, and setting the pressure in the storage tube 140 at 30 Pa.

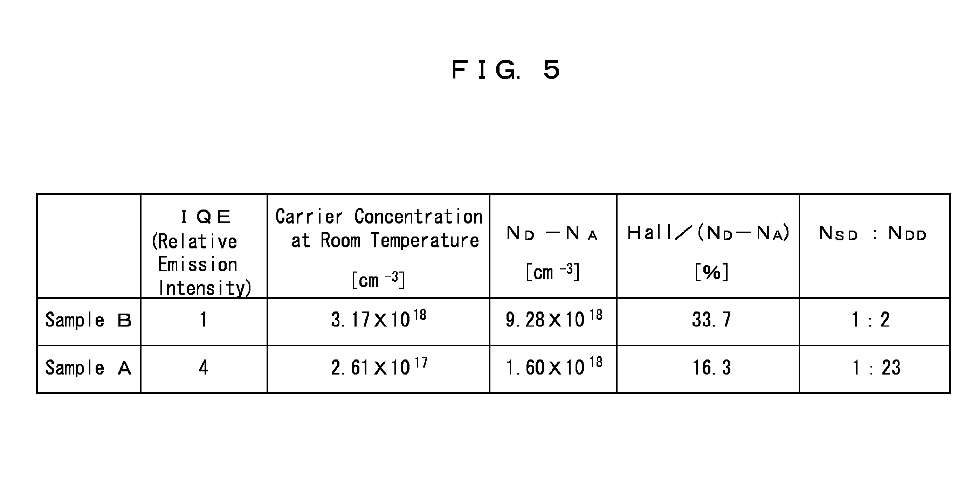

A relative emission intensity, a carrier concentration at room temperature, a difference between donor impurity and acceptor impurity, a ratio of Hall to the difference, and a ratio of a donor forming a shallow donor level to a donor forming a deep donor level of samples A and B thus manufactured by the above manner were measured. The results are as shown in Fig. 5. Fig. 5 is a table showing the relative emission intensity, the carrier concentration at room temperature, a difference between a donor impurity and an acceptor impurity, a ratio of Hall to the difference, and a ratio of a donor forming a shallow donor level to a donor forming a deep donor level of samples A and B. Here, Hall means the carrier concentration obtained by the Hall effect measurement at room temperature.

As is apparent from Fig. 5, in sample A, the addition of hydrogen during the crystal growth suppressed substitution of a donor impurity with carbon atoms in the hexagonal site, thus accelerating substitution with carbon atoms in the cubic site. As a result, the emission intensity increased by four times as compared with sample B. Regarding sample A, it is understood that since the donor concentration at room temperature is smaller than a difference between the donor concentration and the acceptor concentration, and thus accurately donor-acceptor pair emission is performed. Furthermore, in sample A, a ratio of Hall to the difference between the donor concentration and the acceptor concentration becomes smaller than that of sample B, nitrogen as a donor contributes to donor-acceptor pair emission without causing the generation of excess free carriers, as compared with sample B.

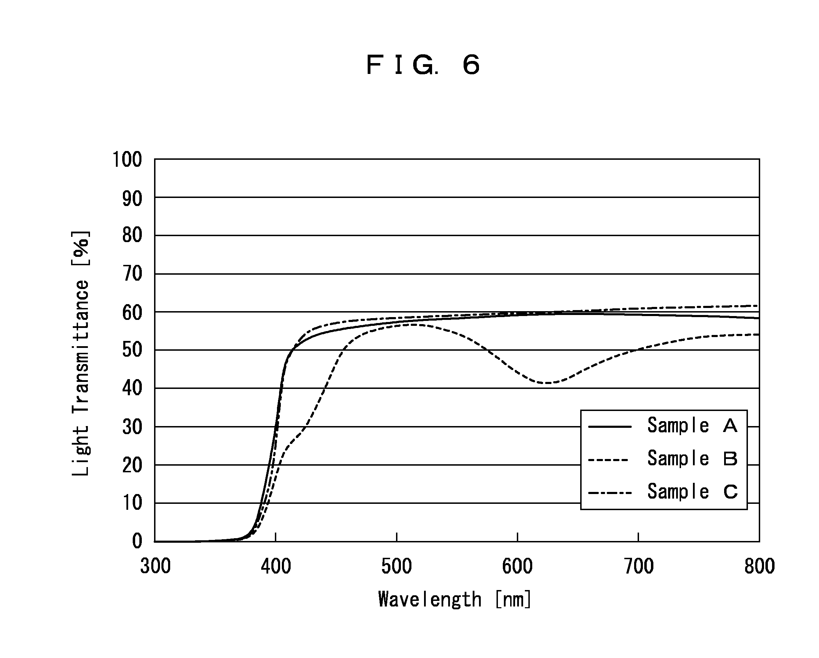

With respect to samples A and B, a light transmittance and an absorption coefficient were measured. For comparison, sample C consisting of an impurity-free 6H-type SiC crystal was manufactured and a comparison was made with a light transmittance thereof. Here, sample C was manufactured under the conditions of an initial temperature of 1,100°C, a growth temperature of 1,780°C, and growth rate of 100 µm/hour. Fig. 6 is a graph showing relation between the wavelength and the light transmittance with respect to samples A, B, and C.

As shown in Fig. 6, it is understood that comparatively small amount of donors having a shallow level exist since the light transmittance in a visible light region of sample A is the same level as that of sample C in which no impurity is added. To the contrary, it is understood that comparatively large amount of donors having a shallow level exist since the light transmittance in a visible light region of sample B is smaller than that of sample C.

While the description was made of the embodiment in which a SiC fluorescent material is obtained by a sublimation method, a SiC fluorescent material may be obtained by a CVD method. While the description was made of the embodiment in which carbon atom in the hexagonal site is preferentially substituted with a donor impurity by adding a hydrogen gas during the crystal growth, other methods can also be used and it is also possible by accurately control a ratio of Si to C.

While the description was made of the embodiment in which a SiC fluorescent material is used as a substrate of a light emitting diode element 1, it is also possible to use as a phosphor which is quite different from that of a light source. For example, a SiC fluorescent material can be used in the form of a powder or plate.

While the description was made of the embodiment in which N and B are used as a donor and an acceptor, it is also possible to use other group V elements and group III elements, for example, P, As, Sb, Ga, In, Al, and the like, and it is also possible to use transition metals such as Ti and Cr, and group II elements such as Be. The donor and acceptor can be appropriately changed if it is an element which is usable as a donor impurity and an acceptor impurity in a SiC crystal. For example, use of N and Al enables emission of light at the shorter wavelength side than that in the case of a combination of N and B.

While the description was made of the embodiment in which the present invention is applied to a 6H-type SiC crystal, needless to say, a crystal including cubic and hexagonal sites, like a 4H-type SiC crystal, can be applied to other poly-type SiC crystals.

### [Reference Signs List]

- 100: Crystal growth apparatus
- 110: Seed crystal substrate
- 120: Raw material
- 130: Inner container
- 131: Crucible
- 132: Lid
- 140: Storage tube
- 150: Heat insulating container
- 160: Introduction tube
- 170: Flowmeter
- 180: Pump
- 190: RF coil

## Claims

1. A SiC fluorescent material comprising a SiC crystal in which a carbon atom is disposed in a cubic site and a hexagonal site, and a donor impurity and an acceptor impurity added therein, wherein a ratio of a donor impurity to be substituted with a carbon atom in a cubic site to a donor impurity to be substituted with a carbon atom in a hexagonal site is larger than a ratio of the cubic site to the hexagonal site in a crystal structure.

2. The SiC fluorescent material according to claim 1, wherein the carrier concentration at room temperature is smaller than a difference between the donor concentration and the acceptor concentration.

3. The SiC fluorescent material according to claim 1 or 2, wherein an absorbance in a visible light region is about the same level as that in the case of adding no impurity.

4. A method for manufacturing a SiC fluorescent material, which comprises growing the SiC fluorescent material in a hydrogen-containing atmosphere by a sublimation method in the manufacture of the SiC fluorescent material according to any one of claims 1 to 3.

5. A light emitting element comprising: a SiC substrate including the SiC fluorescent material according to any one of claims 1 to 3, and a nitride semiconductor layer formed on the SiC substrate.
